# EUROPEAN PATENT APPLICATION

(11) **EP 1 959 474 A2**
(43) Date of publication of application: **20.08.2008**
(21) Application number: 07121013.2
(22) Date of filing: 19.11.2007
(51) Int. Cl.: H01J 17/49

(54) **Filter and plasma display device thereof**

(30) Priority: 16.02.2007 KR 20070016710
(71) Applicant: LG Electronics Inc., Seoul, 150-721 (KR)
(72) Inventor: Cha, Hong Rae, 137-724 Seoul (KR); Sohn, Ji Hoon, 137-724 Seoul (KR); Cho, Sam Je, 137-724 Seoul (KR); Jang, Woo Sung, 137-724 Seoul (KR); Shin, Woon Seo, 137-724 Seoul (KR)
(74) Representative: Cabinet Plasseraud

(57) **Abstract**

The present invention relates to a plasma display device, and a filter (100) formed in a plasma display panel includes an external light shielding sheet (200) which includes a base unit (200), and a plurality of pattern units (210) that are formed on the base unit, wherein an angle between an electrode (11) that is formed on the substrate (10) adjacent to the filter (100) and the pattern unit is 5° or less. According to the present invention, the plasma display device can effectively realize black images and enhance bright room contrast, as an external light shielding sheet, which absorbs and shields as much external light incident upon a plasma display panel PDP as possible, is disposed at a front of the plasma display panel. In addition, the plasma display device of the present invention may reduce the moire phenomenon, as the patterns of the external light shielding sheet is diagonally formed at an angle with the electrode or the barrier rib formed in the panel.

## Description

### BACKGROUND OF THE INVENTION

### 1. Field of the Invention

The present invention relates to a plasma display device, and more particularly, to a plasma display device in which an external light shielding sheet is formed and disposed at a front of a panel in order to shield external light incident upon the panel so that the bright room contrast of the panel can be enhanced while maintaining the luminance of the panel.

### 2. Description of the Conventional Art

In general, a plasma display panel (PDP) displays images including text and graphic images by applying a predetermined voltage to electrodes installed in a discharge space to cause a gas discharge and then exciting a phosphor with the aid of plasma that is generated as a result of the gas discharge. The PDP is easy to manufacture as a large-dimension, light and thin flat display. Also, the PDP can provide wide vertical and horizontal viewing angles, full colors and high luminance.

However, this PDP has a disadvantage in that the contrast is degraded because black images are recognized as being brighter than they actually are, since external light is reflected on the front surface of the panel due to white phosphors exposed at a panel lower substrate when the flat display panel realizes black images.

### SUMMARY OF THE INVENTION

According to an aspect of the present invention, there is provided a plasma display device, including a plasma display panel (PDP) which is composed of a first substrate and a second substrate coupled to each other; and a filter which is formed at a front of the PDP. The filter includes an external light shielding sheet which includes a base unit, and a plurality of pattern units that are formed on the base unit, wherein an angle between a plurality of electrodes that are formed on the substrate adjacent to the filter and the pattern units is 5°or less.

According to another aspect of the present invention, there is provided a plasma display device, wherein the second substrate includes a plurality of electrodes and a plurality of horizontal barrier ribs that are formed on the electrode in an intersecting direction, and an angle between the barrier ribs and the pattern units is 5°or less.

According to an aspect of the present invention, there is provided a filter, including an external light shielding sheet which includes a base unit; and a plurality of pattern units that are formed on the base unit, wherein an angle between the pattern units and the electrodes formed on the display panel is 5°or less.

According to another aspect of the present invention, there is provided a filter, including an external light shielding sheet which includes a base unit; and a plurality of pattern units that are formed on the base unit, wherein an angle between the pattern units and the horizontal barrier ribs formed on the display panel is 5°or less.

### BRIEF DESCRIPTION OF THE DRAWING

FIG. 1 is a perspective view illustrating a plasma display panel according to an embodiment of the present invention,
FIGS 2A and 2B are cross-sectional views illustrating an external light shielding sheet that is included in a filter according to an embodiment of the present invention,
FIGS 3A and 3B are schematic views illustrating black matrices that are formed on a PDP according to embodiments of the present invention,
FIGS 4A and 4B are views illustrating a front shape of pattern units formed in an external light shielding sheet according to the present invention,
FIGS. 5A to 5F are cross-sectional views illustrating a cross section of an external light shielding sheet according to embodiments of the present invention,
FIG. 6 is a cross-sectional view illustrating an external light shielding sheet for explaining the relationship between the distance of pattern units adjacent to the external light shielding sheet and the height of the pattern units,
FIGS. 7A and 7B are views illustrating an electromagnetic interference (EMI) shielding sheet according to an embodiment of the present invention,
FIGS. 8A and 8B are views illustrating a structure of a filter in which an EMI shielding sheet and an external light shielding sheet are overlapped according to an embodiment of the present invention, and
FIGS 9A to 10B are cross-sectional views illustrating a structure of a filter provided with a plurality of sheets according to embodiments of the present invention.

### DETAILED DESCRIPTION OF THE PREFERRED EMBODIMENT

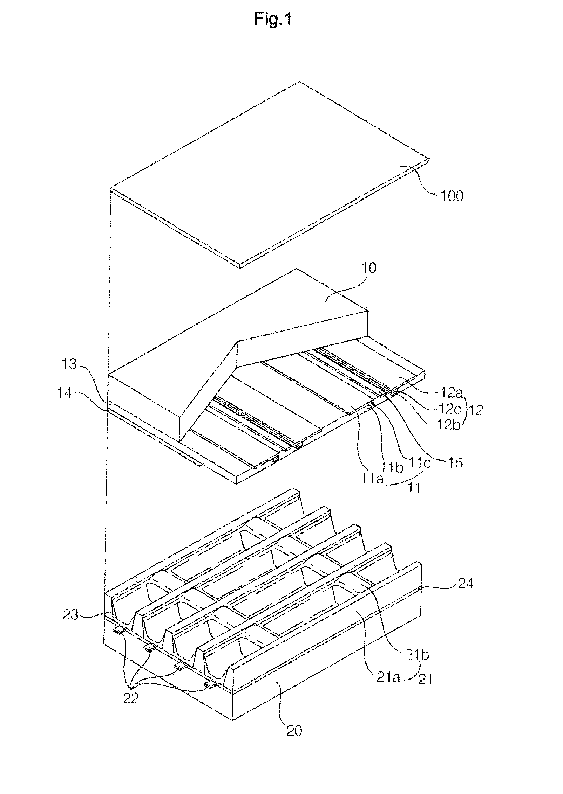

Hereinafter, the present invention will be described in detail with reference to FIGS 1 to 10B, in which exemplary embodiments of the present invention are shown.

As shown in FIG. 1, a PDP includes a scan electrode 11 and a sustain electrode 12, which are a sustain electrode pair formed on an upper substrate 10, and an address electrode 22 formed on a lower substrate 20.

The sustain electrode pair 11 and 12 includes transparent electrodes 11a and 12a and bus electrodes 11b and 12b that are generally made of indium-tin-oxide (ITO). The bus electrodes 11b and 12b can be made of a metal such as silver (Ag) and chrome (Cr) or can be made with a stacked structure of chrome/copper/chrome (Cr/Cu/Cr) or chrome/aluminum/chrome (Cr/Al/Cr). The bus electrodes 11 b and 12b are formed on the transparent electrodes 11a and 12a to reduce voltage drop due to the transparent electrodes 11a and 12a having high resistance.

Meanwhile, according to an embodiment of the present invention, the sustain electrode pair 11 and 12 can be composed of a stacked structure of the transparent electrodes 11 a 12a and the bus electrodes 11 b and 12b or only the bus electrodes 11 b and 12b without the transparent electrodes 11 a and 12a. Because the latter structure does not use the transparent electrodes 11a and 12a, there is an advantage in that a cost of manufacturing a panel can be decreased. The bus electrodes 11 b and 12b used in the structure can be made of various materials such as a photosensitive material in addition to the above-described materials.

A black matrix (BM) 15, which performs a light shielding function of reducing reflection by absorbing external light that is generated from the outside of the upper substrate 10 and a function of improving purity and contrast of the upper substrate 10 is arranged between the transparent electrodes 11 a and 12a and the bus electrodes 11 b and 12b of the scan electrode 11 and the sustain electrode 12.

The black matrix 15 according to an embodiment of the present invention is formed in the upper substrate 10 and includes a first black matrix 15 that is formed in a position that is overlapped with a barrier rib 21 and second black matrixes 11c and 12c that are formed between the transparent electrodes 11a and 12a and the bus electrodes 11 b and 12b. Here, the first black matrix and the second black matrixes 11c and 12c that are also referred to as a black layer or a black electrode layer may be physically coupled to each other when they are formed at the same time in a forming process or may be not physically coupled to each other when they are not formed at the same time.

In addition, when they are physically coupled to each other, the first black matrix 15 and the second black matrixes 11c and 12c are made of the same material, but when they are physically separated from each other, they may be made of other materials.

An upper dielectric layer 13 and a protective film 14 are stacked in the upper substrate 10 in which the scan electrode 11 and the sustain electrode 12 are formed in parallel. Charged particles, which are generated by a discharge are accumulated in the upper dielectric layer 13 and perform a function of protecting the sustain electrode pair 11 and 12. The protective film 14 protects the upper dielectric layer 13 from sputtering of charged particles that are generated at a gas discharge and enhances emission efficiency of a secondary electron.

In addition, the address electrode 22 is formed in an intersecting direction of the scan electrode 11 and the sustain electrode 12. Furthermore, a lower dielectric layer 24 and a barrier rib 21 are formed on the lower substrate 20 in which the address electrode 22 is formed.

In addition, a phosphor layer 23 is formed on the surface of the lower dielectric layer 24 and the barrier rib 21. In the barrier rib 21, a plurality of vertical barrier ribs 21a and a plurality of horizontal barrier ribs 21b are formed in a closed manner and the barrier rib 21 physically divides a discharge cell and prevents ultraviolet rays and visible light that are generated by a discharge from leaking to adjacent discharge cells.

Referring to FIG. 1, a filter 100 is preferably formed at a front of a PDP according to the present invention, and the filter includes an external light shielding sheet, an AR (anti-reflection) sheet, a NIR (near infrared) shielding sheet and an EMI shielding sheet, a diffusion sheet and an optical sheet.

In case that the distance between the filter 100 and the PDP is 10µm to 30µm, it is possible to effectively shield light incident upon the PDP and to effectively emit light generated from the panel to the outside. Also, the distance between the filter 100 and the PDP may be 10µm to 120µm in order to protect the PDP from the exterior pressure, and an adhesion layer, which absorbs impact, may be formed between the filter 100 and the PDP.

In an embodiment of the present invention, various shapes of barrier rib 21 structure as well as the barrier rib 21 structure shown in FIG. 1 can be used. For example, a differential barrier rib structure in which the vertical barrier ribs 21a and the horizontal barrier ribs 21b have different heights, a channel type barrier rib structure in which a channel, which can be used as an exhaust passage is formed in at least one of the vertical barrier ribs 21 a and the horizontal barrier ribs 21 b, and a hollow type barrier rib structure in which a hollow is formed in at least one of the vertical barrier ribs 21a and the horizontal barrier ribs 21 b, can be used.

In the differential type barrier rib structure, it is more preferable that a height of the horizontal barrier ribs 21b is greater than that of the vertical barrier ribs 21 a and in the channel type barrier rib structure or the hollow type barrier rib structure, it is preferable that a channel or a hollow is formed in the horizontal barrier ribs 21 b.

Meanwhile, in an embodiment of the present invention, it is described as each of R, G, and B discharge cells is arranged on the same line, but they may be arranged in other shapes. For example, delta type of arrangement in which the R, G, and B discharge cells are arranged in a triangle shape may be also used. Furthermore, the discharge cell may have various polygonal shapes such as a quadrilateral shape, a pentagonal shape, and a hexagonal shape.

Furthermore, the phosphor layer 23 emits light by ultraviolet rays that are generated at a gas discharge and generates any one visible light among red color R, green color G, or blue color B light. Here, inert mixed gas such as He+Xe, Ne+Xe, and He+Ne+Xe for performing a discharge is injected into a discharge space that is provided between the upper/lower substrates 10, 20 and the barrier rib 21.

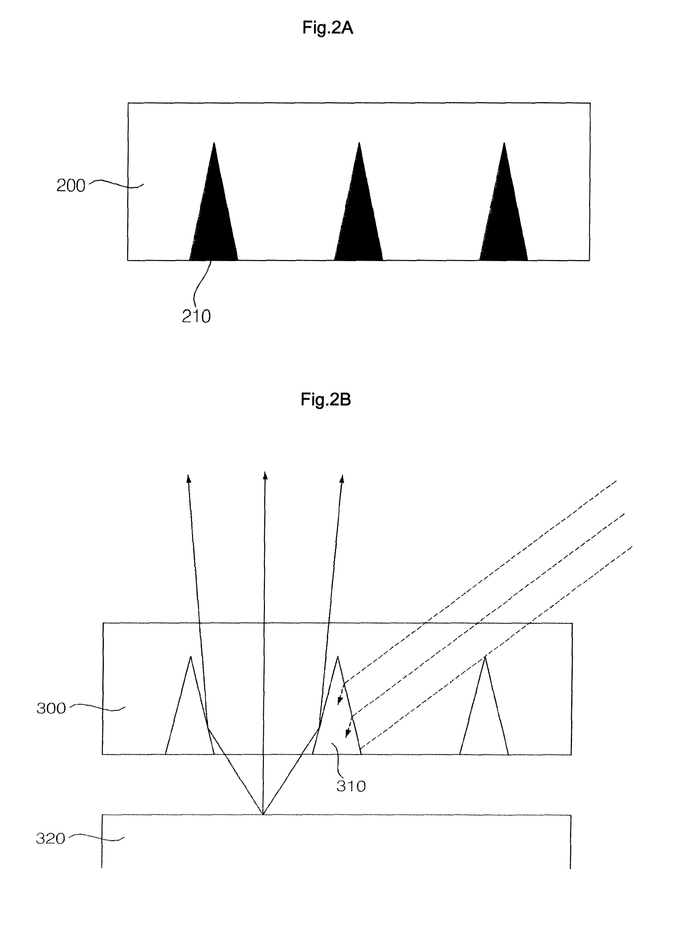

FIG 2A is a cross-sectional view of an external light shielding sheet that is included in a filter according to an embodiment of the present invention. The external light shielding sheet is composed of a base unit 200 and a plurality of pattern units 210.

The base unit 200 is preferably formed of a transparent plastic material, for example a UV-hardened resin-based material, so that light can smoothly transmit therethrough. Alternately, the base unit 400 is possible to use a hard glass material to protect the front of the panel.

Referring to FIG. 2A, the pattern unit 210 may formed as various shapes as well as triangles. The pattern unit 210 is formed of a darker material than the base unit 200. For example, the pattern unit 210 is formed of a black carbon-based material or covered with a black dye in order to maximize the absorption of external light.

According to FIG. 2A, a bottom of the external light shielding sheet is a panel side, and a top of the external light shielding sheet is a viewer side. In general, an external light source is mostly located over the panel, and thus external light may be incident on the panel from the top side at an angle.

It is preferable that the refractive index of the pattern unit 210, at least a slanted surface of the pattern unit 210, is lower than the refractive index of the base unit 200 in order to absorb and shield external light and to enhance the reflection ratio by total reflecting light emitted from the panel.

In addition, the pattern unit 210 may include a light-absorbing particle, and the light-absorbing particle may be a resin particle colored by a specific color. In order to maximize the light absorbing effect, the light-absorbing particle is preferably colored by a black color.

In order to maximize the absorption of external light and to facilitate the manufacture of the light-absorbing particle and the insertion into the pattern unit 210, the size of the light-absorbing particle may be 1µm or more. Also, in case that the size of the light-absorbing particle is 1µm or more, the pattern unit 210 may include the light-absorbing particle 10% weight or more in order to absorb external light more effectively. That is, the light-absorbing particle 10% weight or more of the total weight of the pattern unit 210 may be included in the pattern unit 210.

FIG 2A is a cross-sectional view illustrating a structure of an external light shielding sheet according to an embodiment of the present invention in order to explain the external light shielding function and the panel light reflection function of the external light shielding sheet.

As described in the above, external light which reduces the bright room contrast of the PDP is highly likely to be above the panel. Referring to FIG. 2B, according to Snell's law, external light (illustrated as a dotted line) that is diagonally incident upon the external light shielding sheet is refracted into and absorbed by the pattern unit 310 which has a lower refractive index than the base unit 300. External light refracted into the pattern unit 310 may be absorbed by the light absorption particle.

Also, light (illustrated as a solid line) that is emitted from the panel 320 for displaying is totally reflected from the slanted surface of the pattern unit 310 to the outside, i.e., toward the viewer.

As described above, external light (illustrated as a dotted line) is refracted into and absorbed by the pattern unit 310 and light (illustrated as a solid line) emitted from the panel 320 is totally reflected by the pattern unit 310 because the angle between the external light and the slanted surface of the pattern unit 310 is greater than the angle between the light emitted from the panel 320 and the slanted surface of the pattern unit 310, as illustrated in FIG. 2B.

Therefore, the external light shielding sheet according to the present invention can enhance the bright room contrast of the display image by absorbing the external light to prevent the external light from being reflected toward the viewer and by increasing the reflection of light emitted from the panel 320.

In order to maximize the absorption of external light and the total reflection of light emitted from the panel 320 in consideration of the angle of external light incident upon the panel 320, the refractive index of the pattern unit 310 is preferably 0.3 - 1 times greater than the refractive index of the base unit 300. In order to maximize the total reflection of light emitted from the panel 320 in consideration of the vertical viewing angle of the PDP, the refractive index of the pattern unit 310 is preferably 0.3 - 0.8 times greater than the refractive index of the base unit 300.

When the refractive index of the pattern units 310 is lower than the refractive index of the base unit 300, light emitted from a panel 320 is reflected by the surfaces of the pattern units 310 and thus spreads out toward the user, thereby resulting in unclear, blurry images, i.e., a ghost phenomenon.

When the refractive index of the pattern units 310 is higher than the refractive index of the base unit 300, external light incident upon the pattern units 310 and light emitted from a panel 320 are both absorbed by the pattern units 310. Therefore, it is possible to reduce the probability of occurrence of the ghost phenomenon.

In order to absorb as much panel light as possible and thus to prevent the ghost phenomenon, the refractive index of the pattern units 310 may be 0.05 or more higher than the refractive index of the base unit 300.

When the refractive index of the pattern units 310 is higher than the refractive index of the base unit 300, the transmissivity and contrast of an external light shield sheet may decrease. In order not to considerably reduce the transmissivity and contrast of an external light shield sheet while preventing the ghost phenomenon, the refractive index of the pattern units 310 may be 0.05 - 0.3 higher than the refractive index of the base unit 300. Also, in order to uniformly maintain the contrast of a panel 320 while preventing the ghost phenomenon, the refractive index of the pattern units 310 may be 1.0 - 1.3 times greater than the refractive index of the base unit 300.

FIGS. 2B illustrate the situation when the bottoms of pattern units 310 faces toward a panel 320. But the bottoms of pattern units 310 may face toward a user, and the tops of pattern units 310 may face toward a panel 320. In this case, external light is absorbed by the bottoms of the pattern units 310, thereby enhancing the shielding of external light. The distance between a pair of adjacent pattern units 310 may be widened compared to the distance between a pair of adjacent pattern units 310. Therefore, it is possible to enhance the aperture ratio of an external light shield sheet.

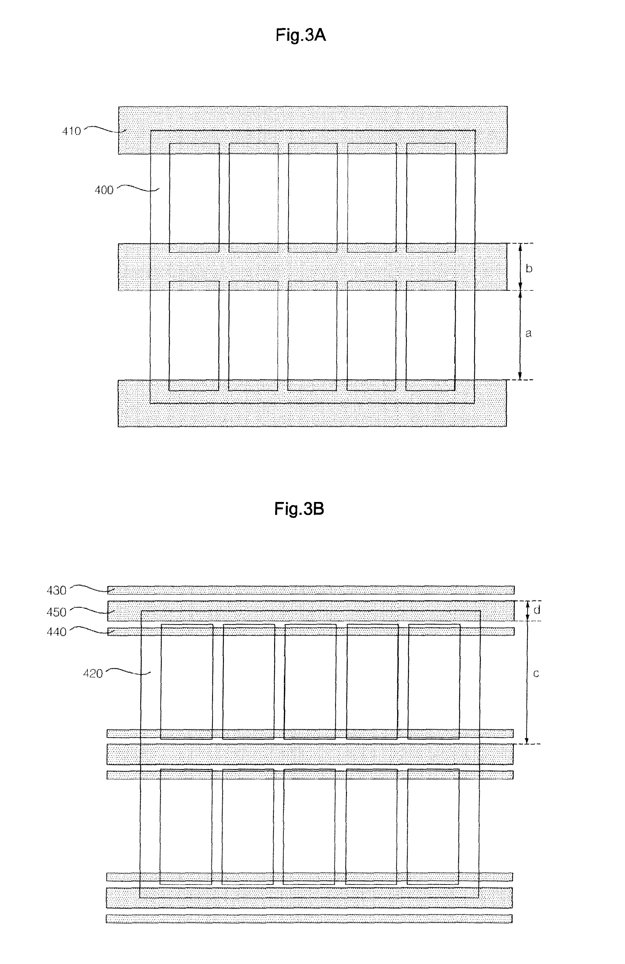

FIGS 3A and 3B are schematic views illustrating a structure of black matrices that are formed on a PDP according to embodiments of the present invention.

Referring to FIG. 3A, a black matrix 410 is formed in a position that is overlapped with a horizontal barrier rib formed on the lower substrate 400. Also, the black matrix 410 is formed in a position that is overlapped with a scan electrode and a sustain electrode formed on the upper substrate, and thus the scan electrode and the sustain electrode are covered with the black matrix 410.

In this case, when the width b of the black matrix 410 is 200µm to 400µm and the distance a of the adjacent black matrices is 300µm to 600µm, opening ratio of the panel for making display images to have appropriate luminance may be obtained as well as which performs a light shielding function of reducing reflection by absorbing external light that is generated from the outside and a function of improving purity and contrast of the upper substrate 10 can be optimized.

Referring to FIG. 3B, the black matrix 450 is formed at a predetermined spacing from the scan electrode and sustain electrode 430, 440 formed on the upper substrate.

In this case, when the width d of the black matrix 410 is 70µm to 150µm and the distance c of the adjacent black matrices is 500µm to 800µm, opening ratio of the panel for making display images to have appropriate luminance may be obtained as well as which performs a light shielding function of reducing reflection by absorbing external light that is generated from the outside and a function of improving purity and contrast of the upper substrate can be optimized.

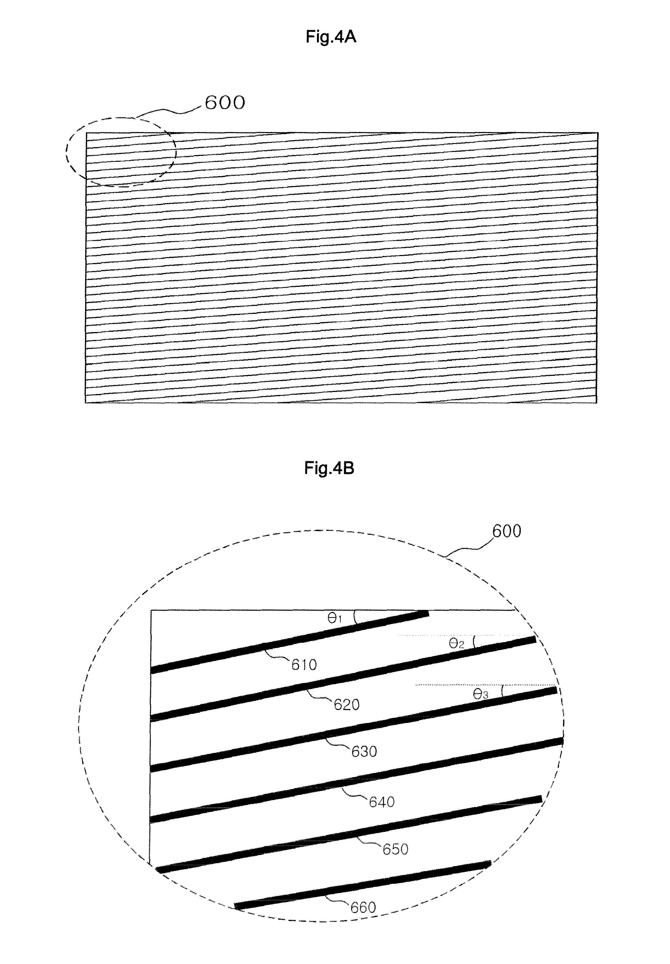

FIGS 4A and 4B are views illustrating a front shape of pattern units formed in an external light shielding sheet according to the present invention. As shown in the drawings, the pattern units are preferably arranged on the base unit spaced apart from each other by a predetermined distance, and they are diagonally formed at an angle with top or bottom of the external light shielding sheet.

As shown in FIG. 4A, the generated by a black matrix or a black layer in the panel is prevented as the pattern unit is diagonally formed at an angle. The moire phenomenon is a pattern of low frequency caused by the interference between periodic image, for example there is a pattern in the shape of wave when mosquito nets are stacked. The moire phenomenon is generated, as the PDP, for example a black matrix, a black layer, a bus electrode and a barrier rib that are formed in the panel and the pattern unit of the external light shielding sheet are overlapped. The moire phenomenon can be reduced by forming the pattern units as illustrated in FIGS. 4A and 4B.

As shown in FIGS. 3A and 3B, the black matrix is parallel to the top or bottom of the external light shielding sheet in FIGS. 4A and 4B, since the black matrix is formed in the upper substrate of the panel in the direction of the horizontal barrier rib formed on the lower substrate of the panel. Therefore, in FIGS. 4A and 4B, the angles Θ₁, Θ₂, Θ₃ between the pattern units and the top of the external light shielding sheet indicate the angles between the pattern units and the black matrix formed in the panel.

The moire phenomenon can be reduced when the pattern units are diagonally formed with the black matrix at an angle of 5°or less. In order to facilitate the formation of the pattern units and prevent a viewing angle of a plasma display device from decreasing, the pattern units are diagonally formed with the black matrix at an angle of 0.15°- 5°.

Also, in consideration that external light incident on the panel is mostly located over the head of an user, the moire phenomenon can be reduced and the reflection efficiency of the light from the panel can be enhanced by obtaining the appropriate opening ratio and thus external light can be effectively shielded when the angle between the pattern units and the black matrix is 1.5 to 3.5°.

FIG. 4B is a magnifying view of some part of the external light shielding sheet 600 in FIG. 4A. The pattern units 610, 620, 630, 640, 650, 660 arranged in a row is preferably parallel to each other, and the angles between the pattern units 610, 620, 630, 640, 650, 660 and the black matrix is preferable within the above-described range even though they are not parallel to each other.

In FIGS. 4A and 4B, the pattern units are diagonally formed from the right-bottom to the left-top of the external light shielding sheet, however the pattern units may be diagonally formed from the left-top to the right-bottom of the external light shielding sheet at the same angle according to another embodiment of the present invention.

The moire phenomenon, which is generated by the overlapping the pattern unit and the bus electrode or the horizontal barrier rib, can be reduced by making the angle between the pattern unit of the external light shielding sheet and the bus electrode or the horizontal barrier rib 5°or less.

In order to facilitate the formation of the pattern units and prevent a viewing angle of a plasma display device from decreasing, the pattern units are diagonally formed with the bus electrode or the horizontal barrier rib at an angle of 0.15°- 5°.

Also, in consideration that external light incident on the panel is mostly located over the head of an user, the moire phenomenon can be reduced and the reflection efficiency of the light from the panel can be enhanced by obtaining the appropriate opening ratio and thus external light can be effectively shielded when the angle between the pattern units and the bus electrode or the angle between the pattern units and the horizontal barrier rib is 1.5 to 3.5°.

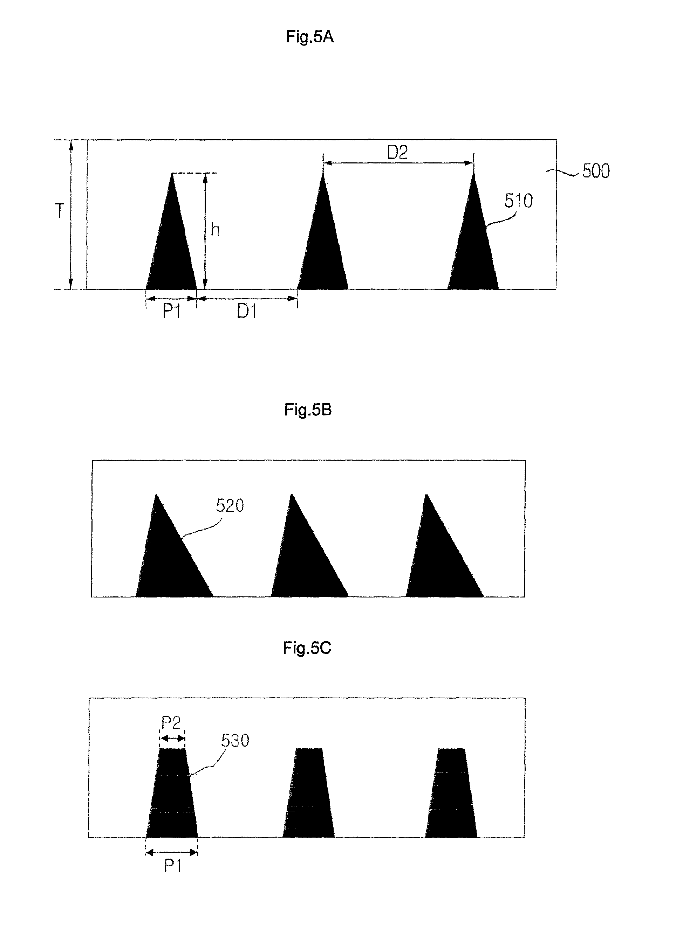

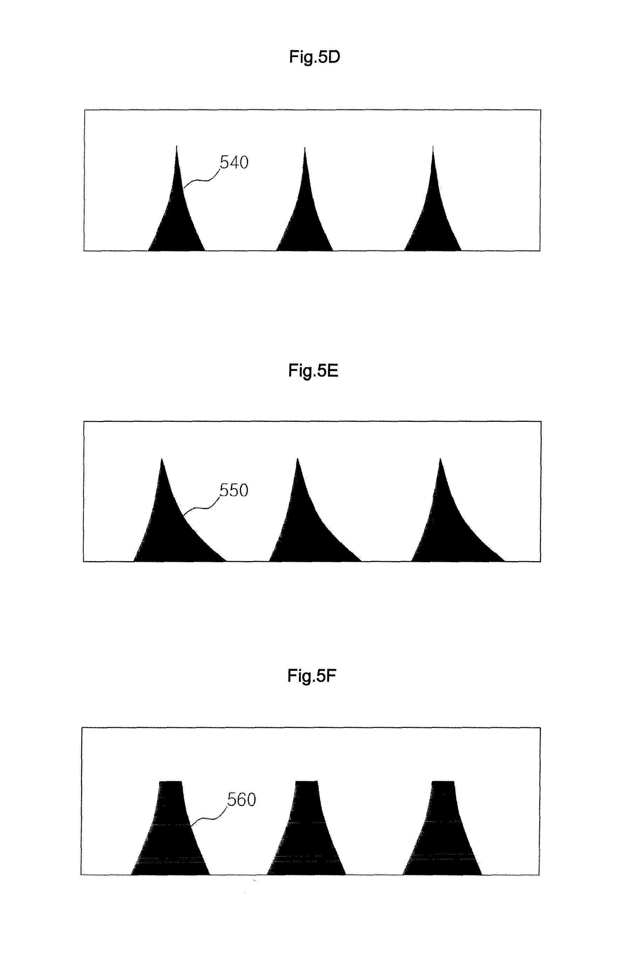

FIGS. 5A to 5F are cross-sectional views illustrating a structure of an external light shielding sheet according to embodiments of the present invention. The external light shielding sheet is composed of a base unit 500 and a pattern unit 510 as illustrated in FIG. 5A.

According to FIG. 5A, a bottom of the external light shielding sheet is a panel side, and a top of the external light shielding sheet is a viewer side in which external light incident on the panel. In general, an external light source is mostly located over the panel, and thus external light may be diagonally incident on the panel from the top side at an angle.

It is preferable that the refractive index of the pattern unit 510, at least a slanted surface of the pattern unit 510, is lower than the refractive index of the base unit 500 in order to absorb and shield external light and to enhance the reflection ratio by total reflecting light emitted from the panel.

External light, which reduces the bright room contrast of the panel, is mostly located over the head of a viewer. Referring to FIG. 5A, according to Snell's law, external light that is diagonally incident upon the external light shielding sheet is refracted into and absorbed by the pattern unit 510 which has a lower refractive index than the base unit 500. External light refracted into the pattern unit 510 may be absorbed by the light absorption particle.

Also, light that is emitted from the panel to the outside for displaying is totally reflected from the slanted surface of the pattern unit 510 to the outside, i.e., toward the viewer.

As described above, external light is refracted into and absorbed by the pattern unit 510 and light emitted from the panel 520 is totally reflected by the pattern unit 510 because the angle between the external light and the slanted surface of the pattern unit 510 is greater than the angle between the light emitted from the panel and the slanted surface of the pattern unit 510.

Therefore, the external light shielding sheet according to the present invention can enhance the bright room contrast of the display image by absorbing the external light to prevent the external light from being reflected toward the viewer and by increasing the reflection of light emitted from the panel.

In order to maximize the absorption of external light and the total reflection of light emitted from the panel in consideration of the angle of external light incident upon the panel, the refractive index of the pattern unit 510 is preferably 0.3 - 1 times greater than the refractive index of the base unit 500. In order to maximize the total reflection of light emitted from the panel in consideration of the vertical viewing angle of the PDP, the refractive index of the pattern unit 510 is preferably 0.3 - 0.8 times greater than the refractive index of the base unit 500.

The base unit 500 is preferably formed of a transparent plastic material, for example a UV-hardened resin-based material, so that light can smoothly transmit therethrough. Alternately, the base unit is possible to use a hard glass material to protect the front of the panel.

Referring to FIG. 5A, the pattern unit 510 may formed as various shapes as well as triangles. The pattern unit 510 is formed of a darker material than the base unit 500. For example, the pattern unit 510 is formed of a black carbon-based material or covered with a black dye in order to maximize the absorption of external light.

In addition, the pattern unit 510 may include a light-absorbing particle, and the light-absorbing particle may be a resin particle colored by a specific color. In order to maximize the light absorbing effect, the light-absorbing particle is preferably colored by a black color.

In order to maximize the absorption of external light and to facilitate the manufacture of the light-absorbing particle and the insertion into the pattern unit 510, the size of the light-absorbing particle may be 1µm or more. Also, in case that the size of the light-absorbing particle is 1µm or more, the pattern unit 510 may include the light-absorbing particle 10% weight or more in order to absorb external light more effectively. That is, the light-absorbing particle 10% weight or more of the total weight of the pattern unit 510 may be included in the pattern unit 510.

When the thickness T of the external light shielding sheet is 20µm to 250µm, the manufacture of the external light shielding sheet can be facilitated and the appropriate light transmittance ratio of the external light shielding sheet can be obtained. The thickness T may be set to 100µm to 180µm in order to effectively absorb and shield external light refracted into the pattern units 510 and to enhance the durability of the external light shielding sheet.

Referring to FIG. 5A, the pattern units 510 formed on the base unit 500 may be formed as triangles, and more preferably, as equilateral triangles. Also, the bottom width P1 of the pattern units 510 may be 18µm to 35µm, and in this case, it is possible to ensure an optimum opening ratio and maximize external light shielding efficiency so that light emitted from the panel can be smooth discharged toward the user side.

The height h of the pattern units 510 is set to 80µm to 170µm, and thus the pattern units 510 can form a gradient capable of effectively absorbing external light and reflecting light emitted from the panel. Also, the pattern units 510 can be prevented from being short-circuited.

In order to achieve a sufficient opening ratio to display images with optimum luminance through discharge of light emitted from the panel toward the user side and to provide an optimum gradient for the pattern unit 510 for enhancing the external light shielding efficiency and the reflection efficiency, the distance D1 between the bottoms of a pair of adjacent pattern units may be set to 40µm to 90µm, and the distance D2 between tops of the pair of adjacent pattern unit may be set to 60µm to 130µm.

Due to the above-described reasons, an optimum opening ratio for displaying images can be obtained when the distance D1 is 1.1 to 5 times greater than the bottom width P1 of the pattern units 510. Also, in order to obtain an optimum opening ratio and to optimize the external light shielding efficiency and the reflection efficiency, the distance D1 between bottoms of the pair of adjacent pattern units may be set to be 1.5 to 3.5 greater than the bottom width.

When the height h is 0.89 to 4.25 times greater than the distance D1 between bottoms of the pair of adjacent pattern units, external light diagonally incident upon the external light shielding sheet from above can be prevented from being incident upon the panel. Also, in order to prevent the pattern units 510 from being short-circuited and to optimize the reflection of light emitted from the panel, the height h may be set to be 1.5 to 3 times greater than the distance D1 between bottoms of the pair of adjacent pattern units.

In addition, when the distance D2 between tops of a pair of adjacent pattern units is 1 to 3.25 times greater than the distance D1 between bottoms of a pair of adjacent pattern units, a sufficient opening ratio for displaying images with optimum luminance can be obtained. Also, in order to maximize the total reflection of light emitted from the panel by the slanted surface of the pattern units 510, the distance D2 between tops of a pair of adjacent pattern units may be set to be 1.2 to 2.5 times greater than the distance D1 between bottoms of a pair of adjacent pattern units.

Referring to FIG. 5B, the respective pattern units 520 may be horizontally asymmetrical. That is, left and right slanted surfaces of the respective pattern units 520 may have different areas or may form different angles with the bottom. in general, an external light source is located above the panel, and thus external light is highly likely to be incident upon the panel from above within a predetermined angle range. Therefore, in order to enhance the absorption of external light and the reflection of light emitted from the panel, an upper slanted surface of the pattern units 510 may be less steep than a lower slanted surface of the pattern units 510. That is, the slope of the upper slanted surface of the pattern units 510 may be less than the slope of the lower slanted surface of the pattern units 510.

Referring to FIG. 5C, the pattern units 530 may be trapezoidal, and in this case, the top width P2 of the pattern units 530 is less than the bottom width P1 of the pattern units 530. Also, the top width P2 of the pattern units 530 may be 10µm or less, and therefore the slope of the slanted surfaces can be determined according to the relationship between the bottom width P1 so that the absorption of external light and the reflection of light emitted from the panel can be optimized.

As shown in FIGS. 5D to 5F, the pattern units illustrated in FIGS. 5A to 5C may have a curved profile. Also, the top or bottom of the pattern units may have a curved profile.

In addition, according to the embodiments of the pattern units, the pattern units may have curved edges having a predetermined curvature, and the pattern units may have outwardly extending curved edges at the bottom.

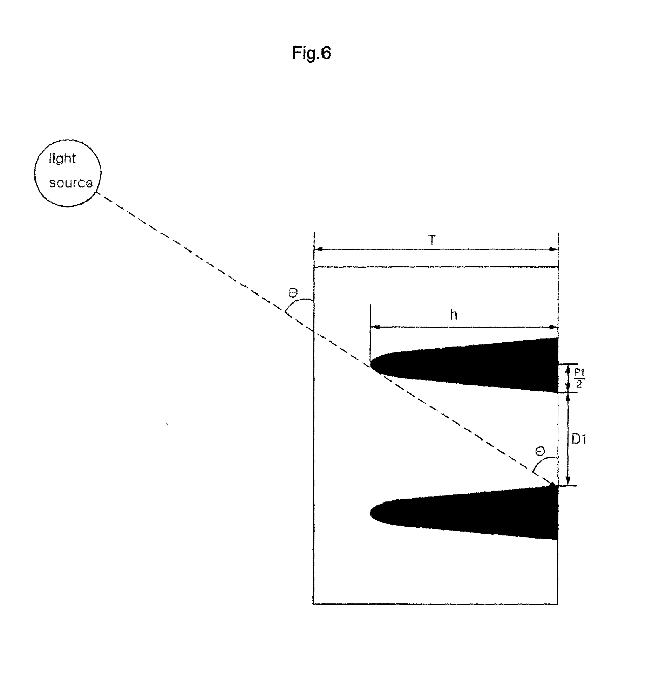

FIG. 6 is a cross-sectional view of an external light shielding sheet according to the present invention and explains the relationship between the thickness of the external light shielding sheet and the height of the pattern units.

Referring to FIG. 6, in order to enhance the durability of the external light shielding sheet including the pattern units and secure the transmission of visible light emitted from the panel for displaying images, the thickness T is preferably 100µm to 180µm.

When the height h is within the range of 80µm to 170µm, the manufacture of the pattern units can be facilitated, an optimum opening ration of the external light shielding sheet can be obtained, and the shielding effect of external light and the reflection effect of light emitted from the panel can be maximized.

The height h of the pattern units can be varied according to the thickness T of the external light shielding sheet. In general, external light that considerably affects the bright room contrast of the panel is highly likely to be incident upon the panel from the above. Therefore, in order to effectively shield external light, the height h of the pattern units is preferably within a predetermined percentage of the thickness T of the external light shielding sheet.

Referring to FIG. 6, as the height h of the pattern units increases, the thickness of the base unit, which is top region of the pattern units, decreases, and thus, dielectric breakdown may occur. On the other hand, as the height h of the pattern units decreases, more external light is likely to be incident upon the panel at various angles within a predetermined range, and thus the external light shielding sheet may not properly shield the external light.

Table 1 presents experimental results about the dielectric breakdown and the external light shielding effect of the external light shielding sheet according to the thickness T of the external light shielding sheet and the height h of the pattern units.

**[Table 1]**

| Thickness (T) of external light shielding sheet | Height (h) of pattern units | Dielectric breakdown | External light shielding |
|---|---|---|---|
| 120µm | 120µm | ○ | ○ |
| 120µm | 115µm | △ | ○ |
| 120µm | 110µm | × | ○ |
| 120µm | 105µm | × | ○ |
| 120µm | 100µm | × | ○ |
| 120µm | 95µm | × | ○ |
| 120µm | 90µm | × | ○ |
| 120µm | 85µm | × | △ |
| 120µm | 80µm | × | △ |
| 120µm | 75µm | × | △ |
| 120µm | 70µm | × | △ |
| 120µm | 65µm | × | △ |
| 120µm | 60µm | × | △ |
| 120µm | 55µm | × | △ |
| 120µm | 50µm | × | × |

Referring to Table 1, when the thickness T of the external light shielding sheet is 120µm or more, and the height h of the pattern units 115µm or more, the pattern units are highly likely to dielectric breakdown, thereby increasing defect rates of the product. When the height h of the pattern units 115µm or less, the pattern units are less likely to dielectric breakdown, thereby reducing defect rates of the external light shielding sheet. However, when the height h of the pattern units is 85µm or less, the shielding efficiency of external light may be reduced, and when the height h of the pattern units is 60µm or less, external light is likely to be directly incident upon the panel.

When the thickness T of the external light shielding sheet is 1.01 to 2.25 times greater than the height h of the pattern units, it is possible to prevent the top portion of the pattern units from dielectrically breaking down and to prevent external light from being incident upon the panel. Also, in order to prevent dielectric breakdown and infiltration of external light into the panel, to increase the reflection of light emitted from the panel, and to secure optimum viewing angles, the thickness T the external light shielding sheet may be 1.01 to 1.5 times greater than the height h of the pattern units.

Table 2 presents experimental results about the occurrence of the moire phenomenon and the external light shielding effect of the external light shielding sheet according to different pattern unit bottom width P1-to-bus electrode width ratios, when the width of the bus electrode formed on the upper substrate of the panel is 90µm.

**[Table 2]**

| Bottom width of pattern units/Width of bus electrodes | Moire | External light shielding |
|---|---|---|
| 0.10 | △ | × |
| 0.15 | △ | × |
| 0.20 | × | △ |
| 0.25 | × | ○ |
| 0.30 | × | ○ |
| 0.35 | × | ○ |
| 0.40 | × | ○ |
| 0.45 | △ | ○ |
| 0.50 | △ | ○ |
| 0.55 | ○ | ○ |
| 0.60 | ○ | ○ |

Referring to Table 2, when the bottom width of the pattern units is 0.2 to 0.5 times greater than the bus electrode width, the moire phenomenon can be prevented and external light incident upon the panel can be reduced. Also, in order to prevent the moire phenomenon, to effectively shield external light, and to secure a sufficient opening ratio for discharging light emitted from the panel, the bottom width P1 of the pattern units is preferably 0.25 to 0.4 times greater than the bus electrode width.

Table 3 presents experimental results about the occurrence of the moire phenomenon and the external light shielding effect according to different pattern unit bottom width of the external light shielding sheet-to-vertical barrier rib width ratios, when the width of the vertical barrier rib formed on the lower substrate of the panel is 50µm.

**[Table 3]**

| Bottom widths of pattern units/Top width of vertical barrier ribs | Moire | External light shielding |
|---|---|---|
| 0.10 | ○ | × |
| 0.15 | △ | × |
| 0.20 | △ | × |
| 0.25 | △ | × |
| 0.30 | × | △ |
| 0.35 | × | △ |
| 0.40 | × | ○ |
| 0.45 | × | ○ |
| 0.50 | × | ○ |
| 0.55 | × | ○ |
| 0.60 | × | ○ |
| 0.65 | × | ○ |
| 0.70 | △ | ○ |
| 0.75 | △ | ○ |
| 0.80 | △ | ○ |
| 0.85 | ○ | ○ |
| 0.90 | ○ | ○ |

Referring to Table 3, when the bottom width P1 is 0.3 to 0.8 times greater than the vertical barrier rib width, the moire phenomenon can be prevented and the amount of external light incident upon the panel can be reduced. Also, in order to prevent the moire phenomenon, to effectively shield external light, and to secure a sufficient opening ratio for discharging light emitted from the panel, the bottom width P1 of the pattern units is preferably 0.4 to 0.65 times greater than the vertical barrier rib width.

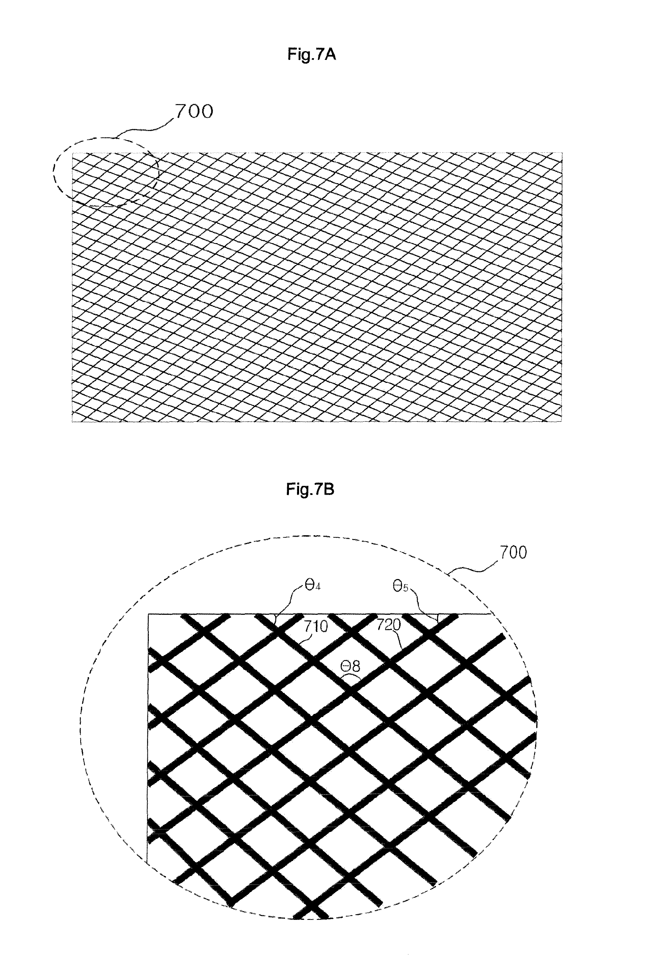

FIGS. 7A and 7B are views illustrating an EMI shielding sheet according to an embodiment of the present invention. The EMI shielding sheet may be formed of a conductive metal such as Cu in a mesh form on the base unit.

As described in the above, according to FIGS. 7A and 7B, angles θ₅, θ₄ between the metal pattern and the top of the EMI shielding sheet indicate the angles between the metal pattern of the EMI shielding sheet and the black matrix formed in the panel.

FIG. 7B is magnifying view illustrating an EMI shielding sheet in FIG. 7A. In the EMI shielding sheet, a first mesh pattern 720 formed from the right-top to the left-bottom and a second mesh pattern 710 formed from the left-top to the right-bottom are formed in a crosswise manner. The first mesh pattern 720 forms an angle θ₅ with the black matrix, and the second mesh pattern 710 forms an angle θ₄ with the black matrix. Also, the first and second mesh patterns 710, 720 are intersected to each other with an angle θ₈.

When the width of the patterns 710, 720 formed in the EMI shielding sheet is 5µm to 15µm, the moire phenomenon can be effectively prevented as the patterns according to the present invention is attached to the external light shielding sheet which is diagonally formed, and appropriate luminance can be maintained by obtaining the EMI shielding effect and obtaining sufficient opening ratio of the PDP.

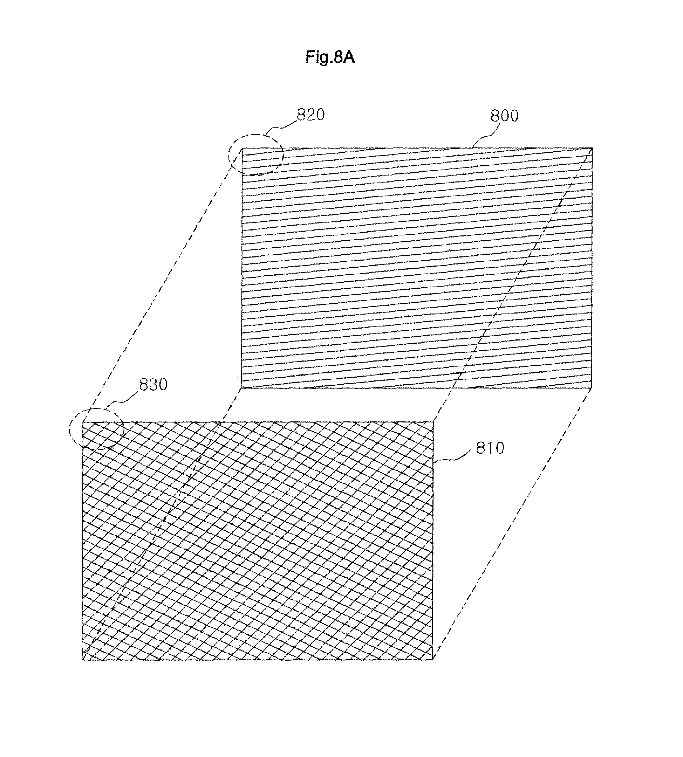

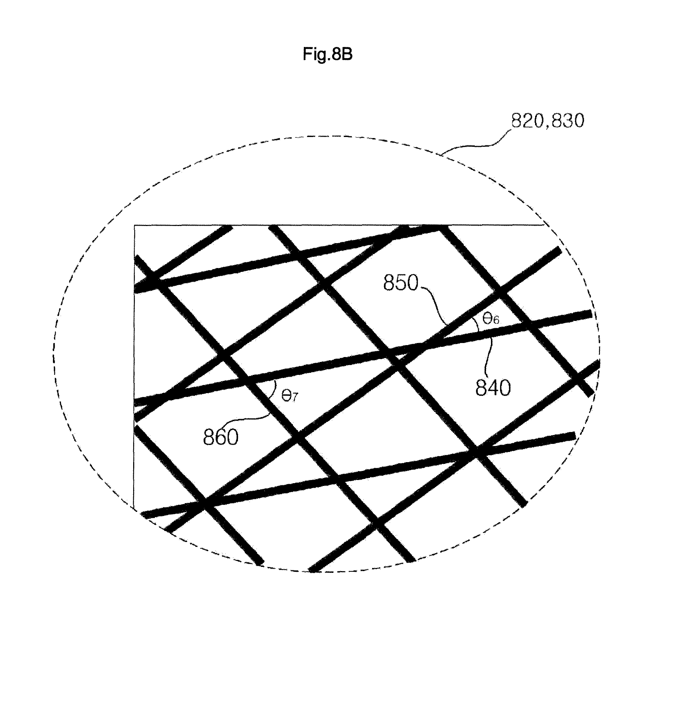

The EMI shielding sheets illustrated in FIGS 7A and 7B is preferably overlapped and attached to the external light shielding sheet which is included in the plasma display device according to the present invention. Hereinafter, the structure of the external light shielding sheet having the EMI shielding sheet will be described in detail with reference to FIGS. 8A and 8B.

In order to secure the EMI shielding effect and to reduce the moire phenomenon, the angles θ₅, θ₄ between the first and second mesh patterns 720, 710 and the black matrix is preferably 20°to 60°. In this case, the angle θ₈ between the first mesh pattern 720 and the second mesh patterns 710 may be 60°to 130°.

In order to eliminate the moire phenomenon through the patterns diagonally formed in the external light shielding sheet, the angles θ₅, θ₄ between the first and second mesh patterns 720, 710 and the black matrix is preferably 30°to 55°. In this case, the angle θ₈ between the first mesh pattern 720 and the second mesh patterns 710 may be 70°to 1180°.

In addition, when the angles θ₅, θ₄ between the first and second mesh patterns 720, 710 and the black matrix is 35°to 45°, the manufacture of the intersecting patterns can be facilitated and an appropriate opening ratio of the plasma display device can be obtained.

FIGS. 8A and 8B illustrate an external light shielding sheet in which an EMI shielding sheet is attached according to an embodiment of the present invention. In order to prevent the moire phenomenon, the EMI shielding sheet 810 as illustrated in FIG. 7A is attached to the external light shielding sheet 800 in which the pattern units are diagonally formed according to the present invention.

FIG. 8B is a magnifying view of some portions 820, 830 of an external light shielding sheet in which an EMI shielding sheet in FIG. 8A according to an embodiment of the present invention. As shown in FIG. 8B, the pattern 840 of the external light shielding sheet and the first and second mesh patterns 850, 860 of the EMI shielding sheet are overlapped.

When the angle θ₆ between the pattern 840 of the external light shielding sheet and the first mesh pattern 850 of the EMI shielding sheet is 20 to 60 degrees, the external light shielding sheet having the EMI shielding sheet may have an EMI shielding effect as well as may reduce the moire phenomenon.

The angle θ₆ between the pattern 840 of the external light shielding sheet and the first mesh pattern 850 of the EMI shielding sheet is preferably 27 to 53 degrees so that the external light shielding sheet shields external light and effectively prevents the moire phenomenon.

Also, in order to obtain the easy manufacture of the pattern, the appropriate opening ratio of the plasma display device and the optimum viewing angles, angle θ₆ between the pattern 840 of the external light shielding sheet and the first mesh pattern 850 of the EMI shielding sheet is preferably 40 to 50 degrees.

When the angle θ₇ between the pattern 840 of the external light shielding sheet and the second mesh pattern 860 of the EMI shielding sheet is 28 to 65 degrees, the external light shielding sheet having the EMI shielding sheet may have an EMI shielding effect as well as may reduce the moire phenomenon.

The angle θ₇ between the pattern 840 of the external light shielding sheet and the second mesh pattern 860 of the EMI shielding sheet is preferably 33 to 58 degrees so that the external light shielding sheet shields external light and effectively prevents the moire phenomenon.

Also, in order to obtain the easy manufacture of the pattern, the appropriate opening ratio of the plasma display device and the optimum viewing angles, angle θ₆ between the pattern 840 of the external light shielding sheet and the second mesh pattern 860 of the EMI shielding sheet is preferably 40 to 50 degrees.

Table 4 presents experimental results about the occurrence of the moire phenomenon according to the angles of the pattern 840 of the external light shielding sheet and the first and second mesh patterns 850, 860 of the EMI shielding sheet, when the angle θ₁ between the pattern 840 of the external light shielding sheet and the black matrix is fixedly set to be 2.5 degrees which is an optimal value and the angle of the first and second mesh patterns 850, 860 of the EMI shielding sheet is controlled.

According to Table 4, 'o' means that the moire phenomenon occurs, 'Δ' means that the moire phenomenon is reduced at a 50% or less, and '×' means that the moire phenomenon is prevented.

**[Table 4]**

| | | | | | | |
|---|---|---|---|---|---|---|
| θ₁ | θ₅ | θ₄ | Moire | θ₈ | θ₆ | θ₇ |
| 2.5 | 5 | 5 | ○ | 170 | 2.5 | 7.5 |
| 2.5 | 5 | 7.5 | ○ | 167.5 | 2.5 | 10 |
| 2.5 | 10 | 10 | ○ | 160 | 7.5 | 12.5 |
| 2.5 | 10 | 12.5 | ○ | 157.5 | 7.5 | 15 |
| 2.5 | 15 | 15 | ○ | 150 | 12.5 | 17.5 |
| 2.5 | 15 | 17.5 | ○ | 147.5 | 12.5 | 20 |
| 2.5 | 20 | 20 | ○ | 140 | 17.5 | 22.5 |
| 2.5 | 20 | 22.5 | ○ | 137.5 | 17.5 | 25 |
| 2.5 | 25 | 25 | ○ | 130 | 22.5 | 27.5 |
| 2.5 | 25 | 27.5 | △ | 127.5 | 22.5 | 30 |
| 2.5 | 30 | 30 | △ | 120 | 27.5 | 32.5 |
| 2.5 | 30 | 32.5 | × | 117.5 | 27.5 | 35 |
| 2.5 | 35 | 35 | × | 110 | 32.5 | 37.5 |
| 2.5 | 35 | 37.5 | × | 107.5 | 32.5 | 40 |
| 2.5 | 40 | 40 | × | 100 | 37.5 | 42.5 |
| 2.5 | 40 | 42.5 | × | 97.5 | 37.5 | 45 |
| 2.5 | 45 | 45 | × | 90 | 42.5 | 47.5 |
| 2.5 | 45 | 47.5 | × | 87.5 | 42.5 | 50 |
| 2.5 | 50 | 50 | × | 80 | 47.5 | 52.5 |
| 2.5 | 50 | 52.5 | × | 77.5 | 47.5 | 55 |
| 2.5 | 55 | 55 | × | 70 | 52.5 | 57.5 |
| 2.5 | 55 | 57.5 | △ | 67.5 | 52.5 | 60 |
| 2.5 | 60 | 60 | △ | 60 | 57.5 | 62.5 |
| 2.5 | 60 | 62.5 | ○ | 57.5 | 57.5 | 65 |
| 2.5 | 65 | 65 | ○ | 50 | 62.5 | 67.5 |
| 2.5 | 65 | 67.5 | ○ | 47.5 | 62.5 | 70 |
| 2.5 | 70 | 70 | ○ | 40 | 67.5 | 72.5 |
| 2.5 | 70 | 72.5 | ○ | 37.5 | 67.5 | 75 |
| 2.5 | 75 | 75 | ○ | 30 | 72.5 | 77.5 |
| 2.5 | 75 | 77.5 | ○ | 27.5 | 72.5 | 80 |
| 2.5 | 80 | 80 | ○ | 20 | 77.5 | 82.5 |
| 2.5 | 80 | 82.5 | ○ | 17.5 | 77.5 | 85 |
| 2.5 | 85 | 85 | ○ | 10 | 82.5 | 87.5 |
| 2.5 | 85 | 87.5 | ○ | 7.5 | 82.5 | 90 |
| 2.5 | 90 | 90 | ○ | 0 | 87.5 | 92.5 |

Referring to Table 4, the moire phenomenon is reduced when the angle θ₅ between the first mesh pattern 850 and the black matrix is 25°to 60°, and the moire phenomenon is effectively prevented when the angle θ₅ between the first mesh pattern 850 and the black matrix is 30°to 55°. Also, the moire phenomenon is reduced when the angle θ₄ between the second mesh pattern 860 and the black matrix is 27.5°to 60°, and the moire phenomenon is effectively prevented when the angle θ₄ between the second mesh pattern 860 and the black matrix is 32.5°to 55°.

The moire phenomenon is reduced when the angle θ₈ between the first mesh pattern 850 and the second mesh pattern 860 is 60°to 127.5°, and the moire phenomenon is effectively prevented when the angle θ₈ between the first mesh pattern 850 and the second mesh pattern 860 is 70°to 117.5°.

The moire phenomenon is reduced when the angle θ₆ between the first mesh pattern 850 and the pattern 840 of the external light shielding sheet is 22.5°to 57.5°, and the moire phenomenon is effectively prevented when the angle θ₆ between the first mesh pattern 850 and the pattern 840 of the external light shielding sheet is 27.5°to 52.5°. Also, the moire phenomenon is reduced when the angle θ₇ between the second mesh pattern 860 and the pattern 840 of the external light shielding sheet is 30°to 62.5°, and the moire phenomenon is effectively prevented when the angle θ₇ between the second mesh pattern 860 and the pattern 840 of the external light shielding sheet is 35°to 57.5°.

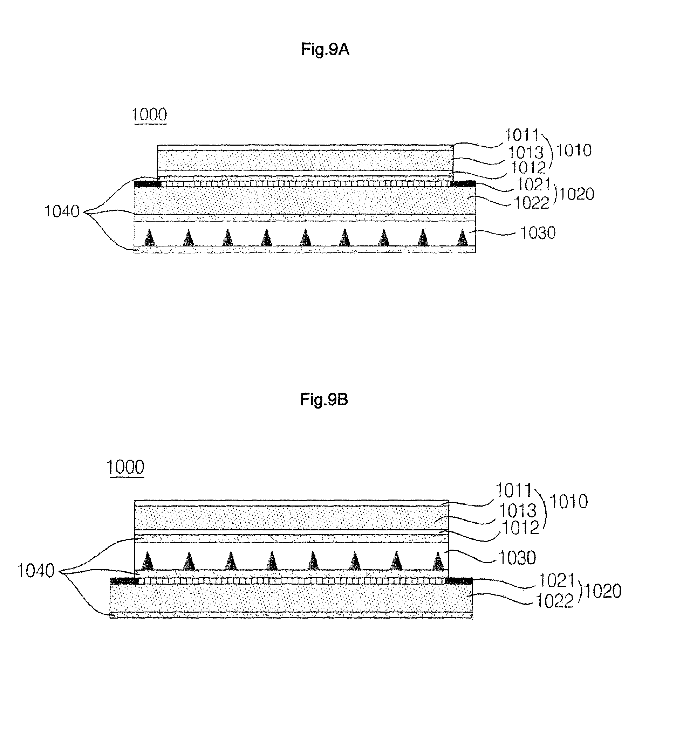

FIGS 9A to 10B are cross-sectional views illustrating a structure of a filter provided with a plurality of sheets according to embodiments of the present invention. The filter formed at a front of the PDP may include an AR/NIR sheet, an EMI shielding sheet, an external light shielding sheet and an optical sheet.

Referring to FIGS. 9A and 9B, an AR (anti-reflection) layer 1011 which is attached onto a front surface of the base sheet 1013 and reduces glare by preventing the reflection of external light from the outside, and a NIR (near infrared) shielding layer 1012 which is attached onto a rear surface of the base sheet and shields NIR rays emitted from the panel so that signals provided by a device such as a remote control which transmits signals using infrared rays can be normally transmitted.

The EMI shielding sheet 1020 includes an EMI shielding layer 1021 which is attached onto a front surface of the base sheet 1022 which is formed of a transparent plastic material and shields EMI emitted from the panel so that the EMI can be prevented from being released to the outside. Here, the EMI shielding layer 1021 is generally formed of a conductive material in a mesh form. An invalid display area of the EMI shielding sheet 1020 where no image is displayed is covered with a conductive material in order to properly ground the EMI shielding layer.

In general, an external light source is mostly located over the head of a viewer regardless of an indoor or outdoor environment. The external light shielding sheet 1030 is attached thereto so that external light is effectively shielded and thus black images of the PDP can be rendered even blacker.

An adhesive layer 1040 is interposed between the AR/NIR sheet 1010, the EMI shielding sheet 1020 and the external light shielding sheet 1030, so that the sheets 1010, 1020, 1030 and the filter 1000 can be firmly attached onto the front surface of the panel. Also, the base sheets interposed between the sheets are preferably made of the same material in order to facilitate the manufacture of the filter 1000.

Meanwhile, referring to FIG. 9A, the AR/NIR sheet 1010, the EMI shielding sheet 1020, and the external light shielding sheet 1030 are sequentially stacked. Alternatively, the AR/NIR sheet 1010, the external light shielding sheet 1030 and the EMI shielding sheet 1020 may be sequentially stacked, as illustrated in FIG. 9B. The order in which the AR/NIR sheet 1010, the EMI shielding sheet 1020 and the external light shielding sheet 1030 are stacked is not restricted to those set forth herein. Also, at least one of the AR/NIR sheet 1010, the EMI shielding sheet 1020 and the external light shielding sheet 1030 can be omitted.

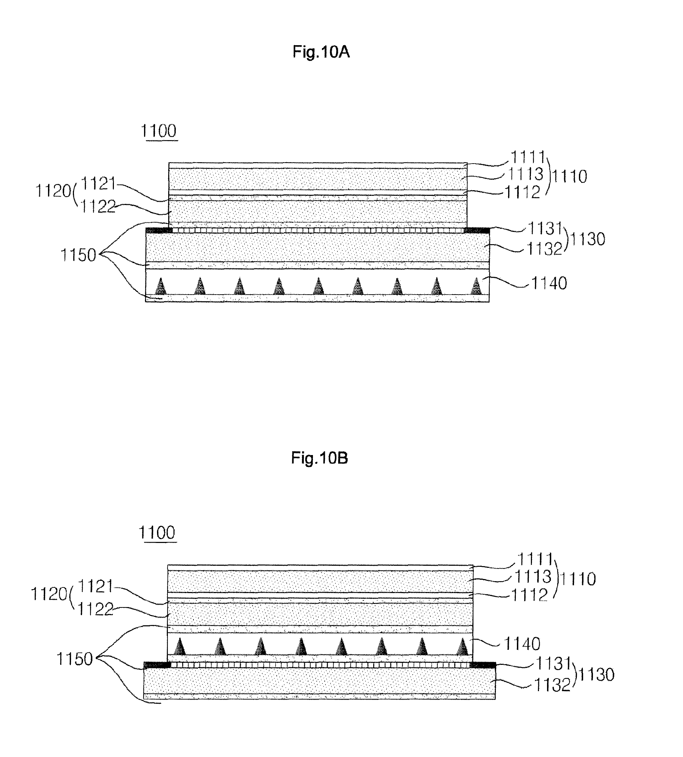

Referring to FIGS. 10A and 10B, a filter 1100 disposed at the front surface of the panel may further include an optical sheet 1120 as well as an AR/NIR sheet 1110, an EMI shielding sheet 1130 and an external light shielding sheet 1140. The optical sheet 1120 enhances the color temperature and luminance properties of light from the panel, and an optical sheet layer 1121 which is formed of a dye and an adhesive is stacked on a front or rear surface of the base sheet 1122 which is formed of a transparent plastic material.

At least one of the base sheets illustrated in FIGS. 9A to 10B may be abbreviated, and at least one of the base sheets may be formed of a hard glass instead of being formed of a plastic material, so that the protection of the panel can be enhanced. It is preferable that the glass is formed at a predetermined spacing apart from the panel.

In addition, the filter according to the present invention may further include a diffusion sheet. The diffusion sheet serves to diffuse light incident upon the panel to maintain the uniform brightness. Therefore, the diffusion sheet may widen the vertical viewing angle and conceal the patterns formed on the external light shielding sheet by uniformly diffusing light emitted from the panel. Also, the diffusion sheet may enhance the front luminance as well as antistatic property by concentrating light in the direction corresponding to the vertical viewing angle.

A transmissive diffusion film or a reflective diffusion film can be used as a diffusion sheet, and the diffusion sheet may have the mixed form that small glass particles are mixed in the base sheet of polymer material. Also, PMMA may be used as a base sheet of the diffusion film. When PMMA is used as a base sheet of the diffusion film, it can be used in large display devices because thermal resistance of the base sheet is good enough despite of it's thick thickness.

The plasma display device of the present invention can effectively realize black images and enhance bright room contrast, as an external light shielding sheet, which absorbs and shields as much external light incident upon a plasma display panel PDP as possible, is disposed at a front of the plasma display panel. In addition, the plasma display device of the present invention may reduce the moire phenomenon, as the patterns of the external light shielding sheet is diagonally formed at an angle with the electrode or the barrier rib formed in the panel.

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. A plasma display device, comprising:
a plasma display panel (PDP) composed of a first substrate and a second
substrate that are coupled to each other; and
a filter which is formed at a front of the PDP, wherein the filter includes an
external light shielding sheet which comprises a base unit, and a plurality of
pattern units that are formed on the base unit, wherein an angle between an
electrode that is formed on the substrate adjacent to the filter and the pattern
units is 5°or less.

2. The plasma display device of Claim 1, wherein the angle between the electrode and the pattern units is 0.15°to 3.5°.

3. The plasma display device of Claim 1, wherein the angle between the electrode and the pattern units is 1.5°to 3.5°.

4. The plasma display device of Claim 1, wherein a bottom width of the pattern units is 0.2 to 0.5 times greater than a width of the electrode.

5. The plasma display device of Claim 1, wherein a refractive index of the pattern units is 0.3 to 1 times greater than a refractive index of the base unit.

6. The plasma display device of claim 1, wherein a refractive index of the pattern units is higher than a refractive index of the base unit.

7. The plasma display device of claim 1, wherein a refractive index of the pattern units is 1.0 to 1.3 times higher than a refractive index of the base unit.

8. The plasma display device of claim 1, wherein a bottom width of the pattern units is greater than a top width of the pattern units, the top of the pattern units is more adjacent to the PDP than the bottom of the pattern units.

9. The plasma display device according to Claim 1, wherein a thickness of the external light shielding sheet is 1.01 to 2.25 times greater than the height of the pattern units.

10. A plasma display device, comprising:
a plasma display panel (PDP) composed of a first substrate and a second
substrate that are coupled to each other; and
a filter which is formed at a front of the PDP, wherein the filter comprises an
external light shielding sheet which comprises a base unit, and a plurality of
pattern units that are formed on the base unit, wherein the second substrate
comprises a plurality of electrodes and a plurality of horizontal barrier ribs
which intersect the electrodes, and an angle between the horizontal barrier
ribs and the pattern units is 5°or less.

11. The plasma display device of Claim 10, wherein the angle between the horizontal barrier ribs and the pattern units is 0.15°to 5°.

12. The plasma display device of Claim 10, wherein the angle between the horizontal barrier ribs and the pattern units is 1.5°to 3.5°.

13. The plasma display device of Claim 10, wherein the second substrate comprises a plurality of vertical barrier ribs which intersect the horizontal barrier ribs, and wherein a bottom width of the pattern units is 0.3 to 0.8 times greater than a top width of the vertical barrier ribs.

14. The plasma display device of claim 10, wherein a refractive index of the pattern units is higher than a refractive index of the base unit.

15. The plasma display device of claim 10, wherein a refractive index of the pattern units is 1.0 - 1.3 times higher than a refractive index of the base unit.

16. The plasma display device of claim 10, wherein a bottom width of the pattern units is greater than a top width of the pattern units, the top of the pattern units is more adjacent to the PDP than the bottom of the pattern units.

17. The plasma display device according to Claim 10, wherein a thickness of the external light shielding sheet is 1.01 to 2.25 times greater than the height of the pattern units.

18. A filter, comprising:
a base unit; and
an external light shielding sheet which comprises pattern units formed on the
base unit, wherein an angle between at least one of a plurality of electrodes
and a plurality of horizontal barrier ribs formed on a display panel and the
pattern units is 5°or less.

19. The filter of Claim 18, wherein the angle between at least one of a plurality of electrodes and a plurality of horizontal barrier ribs formed on a display panel and the pattern units is 0.15°to 5°.

20. The filter of Claim 18, wherein the angle between at least one of a electrode and a horizontal barrier rib formed on a display panel and the pattern units is 1.5°to 3.5°.
